(19) Europäisches Patentamt

European Patent Office

Office européen des brevets

(11) **EP 2 463 669 B1**

(12) **FASCICULE DE BREVET EUROPEEN**

(45) Date de publication et mention
de la délivrance du brevet:
**12.06.2013 Bulletin 2013/24**

(51) Int Cl.:
***G01R 19/155*** *(2006.01)*      ***G01R 15/16*** *(2006.01)*
***G01R 19/165*** *(2006.01)*

(21) Numéro de dépôt: **11192155.7**

(22) Date de dépôt: **06.12.2011**

(54) **Module de détection de tension**

Spannungserfassungsmodul

Voltage detection module

(84) Etats contractants désignés:
**AL AT BE BG CH CY CZ DE DK EE ES FI FR GB
GR HR HU IE IS IT LI LT LU LV MC MK MT NL NO
PL PT RO RS SE SI SK SM TR**

(30) Priorité: **07.12.2010 FR 1004763**

(43) Date de publication de la demande:
**13.06.2012 Bulletin 2012/24**

(73) Titulaire: **Thales
92200 Neuilly Sur Seine (FR)**

(72) Inventeurs:
• **Mancho-Banuls, Salvador
92704 Colombes (FR)**
• **Nennig, Laurent
46500 Gramat (FR)**
• **Pottier, Sébastien
92704 Colombes (FR)**

(74) Mandataire: **Blot, Philippe Robert Emile
Cabinet Lavoix
2, place d'Estienne d'Orves
75441 Paris Cedex 09 (FR)**

(56) Documents cités:
FR-A1- 2 140 263     US-A- 3 611 132
US-A- 4 393 327     US-A- 4 594 546

**Description**

La présente invention concerne un module de détection de tension comprenant :

- une première borne électrique,
- une seconde borne de masse,
- une résistance de charge, reliée à la première borne électrique,
- un éclateur à gaz principal, disposée en série entre la résistance de charge et la seconde borne, et
- un condensateur principal, relié, d'une part, à un premier point milieu situé entre la résistance de charge et l'éclateur à gaz principal et, d'autre part, à la seconde borne.

La présente invention concerne également un système de détection de tension comprenant au moins un module de détection de tension. Le domaine de la détection de haute tension nécessite l'utilisation d'appareils spécifiques tels que des vérificateurs d'absence de tension (VAT) ou des détecteurs de tension (DDT). Ces appareils équipent notamment les bancs d'énergie et servent de moyens de sécurité capables de détecter la tension résiduelle aux bornes des condensateurs pendant et après une utilisation du banc d'énergie. Ces appareils de détection intègrent une électronique de détection qui permet une alimentation d'un indicateur lumineux dans le cas d'une tension détectée supérieure à une tension seuil donnée. Cette électronique de détection comprend généralement un néon formant à la fois une source lumineuse, servant d'indicateur lumineux, et un éclateur à gaz principal connecté à une résistance, ces composants étant reliés en série entre une borne électrique positive et une borne de masse.

On connaît également du document US 4 594 546 A un module de détection de tension comprenant une première borne électrique, une seconde borne de masse, une résistance de charge, reliée à la première borne électrique, un éclateur à gaz principal, disposée en série entre la résistance de charge et la seconde borne, et un condensateur principal, relié, d'une part, à un premier point milieu situé entre la résistance de charge et l'éclateur à gaz principal et, d'autre part, à la seconde borne. Dans ce cas, l'éclateur à gaz sert d'indicateur lumineux.

Compte-tenu de leur architecture en série, ces appareils ne délivrent qu'un courant limité à l'indicateur lumineux lors de la détection de présence de tension.

Par conséquent, la puissance optique émise par l'indicateur lumineux est faible et ne permet pas d'obtenir, dans toutes les conditions, une visibilité suffisante pour une détection par l'oeil humain ou par un dispositif équivalent, ce qui est susceptible d'entraîner des problèmes en termes de sécurité.

Un but de l'invention est donc de fournir un module auto-alimenté de détection de tension propre à émettre une indication lumineuse suffisante pour pouvoir être détectée facilement à distance par l'être humain ou par tous autres dispositifs électroniques de détection.

A cet effet, l'invention a pour objet un module de détection de tension du type précité, caractérisé en ce qu'il comporte, en outre, une source lumineuse reliée en série entre l'éclateur à gaz principal et la seconde borne, en ce que la source lumineuse et l'éclateur à gaz principal sont dissociés l'un de l'autre, et en ce qu'il comprend un étage supplémentaire propre à limiter la tension appliquée aux bornes de l'éclateur à gaz principal à une tension seuil choisie afin d'éviter que l'éclateur à gaz principal ne soit toujours passant...

Suivant d'autres modes de réalisation, le module de détection de tension comprend une ou plusieurs des caractéristiques suivantes, prises isolément ou suivant toutes les combinaisons techniquement possibles :

- il comprend, en outre, une résistance de limitation de courant, reliée en série d'une part à la source lumineuse et d'autre part à la borne de masse,
- la source lumineuse est une diode optique,
- l'étage supplémentaire comprend :

    - une résistance d'étage reliée d'une part au premier point milieu et d'autre part à un second point milieu, ce second point milieu étant relié à la résistance de charge,
    - un éclateur à gaz secondaire à tension d'amorçage spécifique, relié d'une part au second point milieu et d'autre part à un troisième point milieu, dont la tension d'amorçage correspond à la tension seuil choisie pour cet étage supplémentaire,
    - un condensateur secondaire à temps de charge et de décharge spécifique, disposé en parallèle de l'éclateur à gaz secondaire et relié d'une part au second point milieu et d'autre part au troisième point milieu, et
    - une résistance secondaire, reliée d'une part au troisième point milieu et d'autre part à la borne de masse.

- l'étage supplémentaire comprend, en outre, un condensateur antiparasite, disposé en parallèle de la résistance secondaire et relié d'une part au troisième point milieu et d'autre part à la borne de masse,
- les valeurs des résistances et du condensateur principal sont telles que le temps de charge du condensateur principal est compris entre 50ms et 500ms,

- il comprend une pluralité d'étages supplémentaires disposés en parallèle entre la résistance de charge et l'étage principal, un premier étage amont étant relié à la résistance de charge, un dernier étage aval étant relié à l'étage principal, chaque étage amont ayant une tension seuil, correspondant à une tension de protection de l'étage aval associé, supérieure à l'étage aval relié directement, de façon à limiter la tension aux bornes de chaque étage aval, et
- il comprend, en outre, une fibre optique, connectée en sortie de la source lumineuse, propre à transmettre à distance une impulsion lumineuse produite par la source lumineuse.

Selon un autre aspect, l'invention concerne également un système de détection de tension correspondant.

L'invention sera mieux comprise à la lecture de la description qui va suivre, donnée uniquement à titre d'exemple et faite en se référant aux dessins annexés, sur lesquels :

- la figure 1 est un schéma électronique d'un module de détection de tension ,
- la figure 2 est un schéma électronique d'un module de détection de tension comprenant un étage supplémentaire selon un mode de réalisation suivant l'invention,
- la figure 3 est un schéma électronique d'un module de détection de tension comprenant une pluralité d'étages supplémentaires selon un second mode de réalisation suivant l'invention,
- la figure 4 est une représentation schématique d'un système de détection de tension comprenant un module de détection de tension, et
- la figure 5 est une représentation schématique d'un système de détection de tension comprenant N modules de détection de tension.

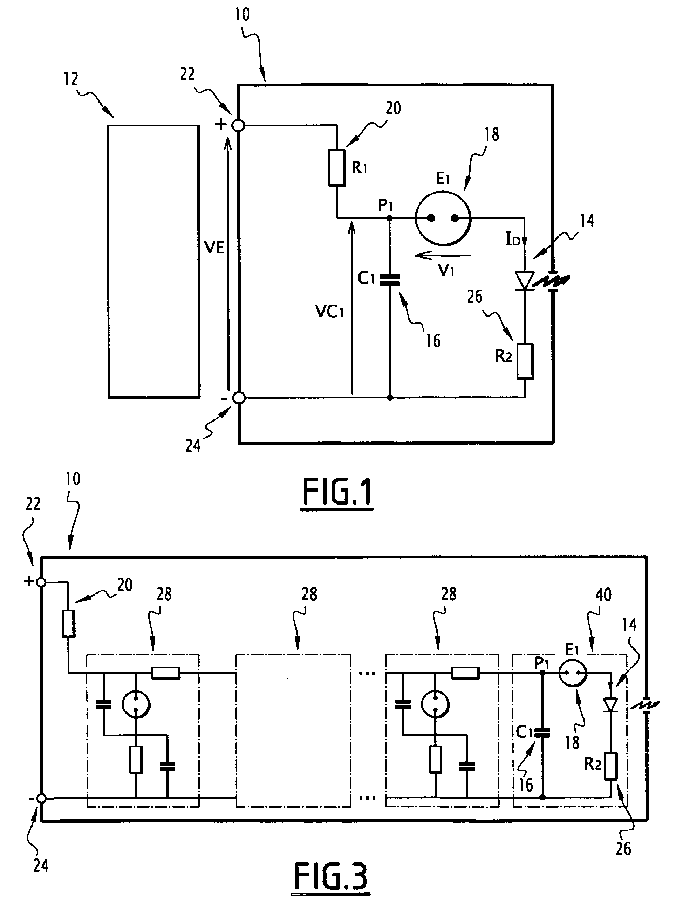

Le module de détection de tension 10 selon l'invention, illustrée sur la figure 1, est placé directement sur l'élément à tester. Plus précisément, le module de détection 10 est placé aux bornes d'une charge 12, par exemple un condensateur propre à générer une tension donnée.

Le module 10 comporte une source lumineuse 14 telle qu'une diode optique reliée à un condensateur principal 16 au travers d'un éclateur à gaz 18. Plus précisément, le condensateur 16 est relié en série avec une résistance de charge 20, au travers d'un point milieu P1, entre une borne 22 de charge positive et une borne de masse 24.

L'éclateur à gaz 18, la diode optique, ainsi qu'une résistance de limitation de courant 26 sont connectés en série aux bornes du condensateur 16.

La résistance 20 a une valeur $R_1$ élevée, telle que R1>10MΩ, afin de limiter le courant au niveau de l'éclateur à gaz 18. La résistance 26 a une valeur $R_2$ faible, telle que 50Ω<$R_2$<200Ω, afin d'avoir, à la fois, un courant suffisant pour alimenter la diode mais pas trop important pour ne pas dépasser l'intensité maximale admissible par cette diode.

A titre d'exemple, les valeurs des résistances sont telles que $R_1$=90MΩ et $R_2$= 100 Ω. Le condensateur 16 a une valeur C1=100nF.

Avantageusement, la diode optique est une diode électroluminescente propre à émettre un rayonnement lumineux en lumière visible.

Le fonctionnement du module de détection 10, tel que représenté sur la figure 1, va être à présent décrit.

Le module de détection 10 a un fonctionnement à deux états.

Lorsque la tension $V_E$ appliquée en entrée, c'est à dire entre les bornes 22 et 24, du module de détection 10 est inférieure à une tension seuil donnée par la tension d'amorçage VA de l'éclateur à gaz 18, le courant, traversant la résistance 20, charge le condensateur 16. Lors de la charge, la tension $V_{C1}$ aux bornes du condensateur 16 croît jusqu'à atteindre la valeur de la tension $V_E$ appliquée en entrée. Dès lors, aucun courant ne circulant à travers la diode et la résistance 26, la tension V1 aux bornes de l'éclateur à gaz 18 correspond à la tension aux bornes du condensateur 16. Comme cette tension est inférieure à la tension d'amorçage VA de l'éclateur à gaz 18, l'éclateur 18 ne se déclenche pas et reste en circuit-ouvert. Ainsi, aucun courant $I_D$ n'alimente la diode optique, de sorte qu'aucun rayonnement lumineux n'est émis vers l'extérieur.

Par conséquent, l'absence de lumière visible en sortie du module de détection 10 indique une tension inférieure à la tension seuil, choisie en fonction du niveau de sécurité souhaité. Par exemple, dans le cas d'un éclateur à gaz 18 présentant une tension d'amorçage VA de 90 V, l'absence de lumière visible correspond à une tension appliquée en entrée inférieure à 90V environ. Dans ce cas, on parle alors d'absence de tension car les niveaux de tension détectés ne sont pas dangereux pour un utilisateur.

Lorsque la tension $V_E$ appliquée en entrée, c'est à dire entre les bornes 22 et 24, du module de détection 10 est supérieure à la tension seuil choisie, correspondant à la tension d'amorçage VA de l'éclateur à gaz 18, le condensateur 16 applique après un certain temps de charge une tension $V_1$, aux bornes de l'éclateur 18, supérieure à cette tension d'amorçage VA. Une décharge se produit, en provoquant un arc électrique, dans l'éclateur à gaz 18 qui se met alors en court-circuit. Le condensateur 16 se décharge rapidement au travers de la diode 18, la résistance 26 étant de faible valeur. L'arc électrique dans l'éclateur s'éteint lorsque la tension de décharge du condensateur 16 devient inférieure à la tension de maintien d'arc de l'éclateur à gaz 18, faisant alors cesser l'illumination de la diode. Le courant électrique $I_D$ lors de la décharge du condensateur 16 a une évolution dans le temps typique, connue de l'homme du métier, et qui est proche de la forme d'une impulsion avec un pic de courant tel que $I=V_E/R_2$.

A titre d'exemple, en prenant $R_2=100\Omega$ et $V_E=90V$, le courant électrique maximum $I_D$ traversant la diode optique a une valeur de 0,9A environ, après le déclenchement de l'éclateur à gaz 18. Grace à ce courant électrique $I_D$, la diode optique émet un vif rayonnement lumineux vers l'extérieur qui prend également la forme d'une impulsion, compte-tenu du caractère impulsionnel du courant décrit précédemment. Tant qu'une tension appliquée en entrée entre les bornes 22 et 24 est supérieure à la tension seuil et inférieure à une tension maximale permettant l'extinction correcte de l'éclateur à gaz 18 après déclenchement, le condensateur 16 alterne des cycles de charge et de décharge à intervalles réguliers. Cette alternance provoque ainsi la génération d'impulsions lumineuses par la diode optique à une fréquence donnée. Plus précisément, la période de clignotement de la diode est égale à la somme du temps de charge et de décharge du condensateur 16. En pratique, le temps de décharge étant très inférieur au temps de charge du fait que la valeur de la résistance 26 est très faible par rapport à la valeur de la résistance 20, la période de clignotement de la diode est égale au temps de charge du condensateur 16.

Ainsi, un clignotement lumineux est visible en sortie, informant un utilisateur de la présence d'une tension supérieure à la tension seuil et donc d'un danger.

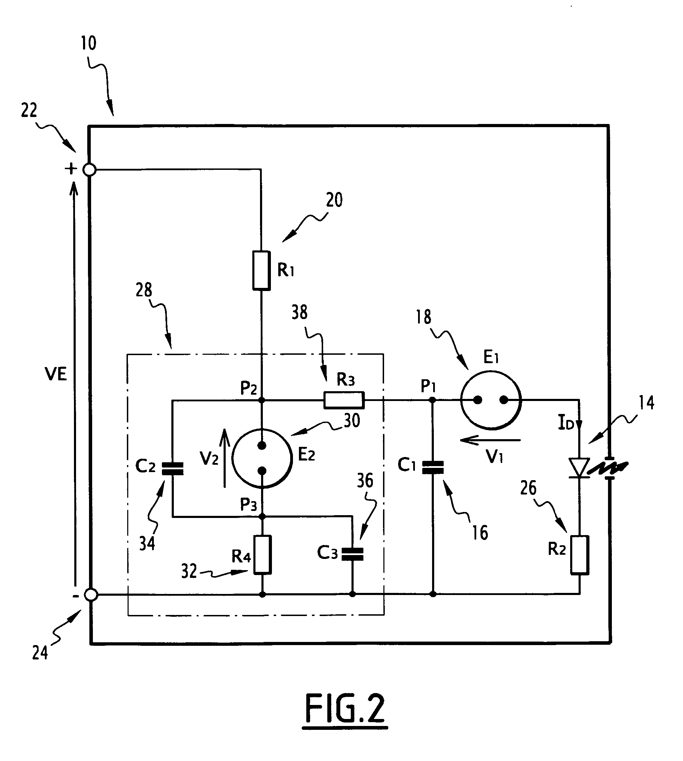

La figure 2 illustre un mode de réalisation d'un module de détection 10 selon l'invention. Il comporte un étage supplémentaire 28 propre à limiter la tension appliquée aux bornes de l'éclateur à gaz 18 à une tension seuil choisie afin d'éviter que l'éclateur à gaz 18 ne soit toujours passant et de pouvoir utiliser le détecteur sur une plage grande dynamique.

L'étage 28 comporte un éclateur à gaz secondaire 30 relié, d'une part à la résistance 20 et, d'autre part, à une résistance secondaire 32. Plus précisément, la résistance 20, l'éclateur à gaz 30 et la résistance 32 sont reliés en série entre les bornes 22 et 24. Un condensateur secondaire 34 est connecté en parallèle de l'éclateur à gaz 30 et est relié d'une part à un condensateur antiparasite 36 et d'autre part à une résistance d'étage 38. De manière détaillée, le condensateur 36 est connecté en parallèle de la résistance 32 alors que la résistance 38 est reliée à l'éclateur à gaz 18 au travers du point milieu P1.

Les résistances 38, 32 ont des valeurs élevées, respectivement $R_3$ et $R_4$, supérieures à 1 M$\Omega$, et sont choisies telles que ces valeurs R3 et R4 soient inférieures à la valeur $R_1$ de la résistance 20. A titre d'exemple, les valeurs des résistances sont telles que $R_3=R_4=R_1/3=30$ M$\Omega$. La valeur du condensateur 34 est choisie de manière à ce que cette valeur C2 soit inférieure à la valeur C1 du condensateur 16 afin que le condensateur 34 se charge plus rapidement que le condensateur 16. Par exemple, le condensateur 34 a une valeur $C_2=470pF$. La valeur du condensateur 36 est faible, par exemple $C_3=100pF$, ce condensateur 36 ayant un rôle d'antiparasite. Pour des tensions $V_E$ en entrée, entre les bornes 22 et 24, inférieures à la tension seuil choisie pour l'étage supplémentaire 28, correspondant à la tension d'amorçage de l'éclateur à gaz 30, le fonctionnement du module de détection 10, tel que représenté sur la figure 2, est similaire à celui décrit précédemment.

Dans le cas d'une tension appliquée en entrée du module de détection 10 supérieure à la tension seuil de l'étage supplémentaire 28, l'éclateur à gaz 30 est sollicité afin d'éviter qu'une tension et un courant trop élevé ne soient appliqués aux bornes de l'éclateur à gaz 18, la tension d'amorçage de l'éclateur à gaz 30 étant inférieure à la tension d'entretien de l'arc électrique de l'éclateur à gaz 18. Ainsi, l'éclateur à gaz 30 évite que l'éclateur à gaz 18 ne soit toujours en court-circuit, en permettant une extinction correcte de l'arc électrique.

Plus particulièrement, dans le cas d'une tension $V_E$ appliquée en entrée supérieure à la tension d'amorçage de l'éclateur à gaz 30, par exemple 4000V, une fois le condensateur 34 chargé, une décharge se produit dans l'éclateur à gaz 30 qui se met alors en court-circuit. Le condensateur 34 se décharge au travers de l'éclateur à gaz 30, ce qui produit une chute de potentiel au niveau d'un point milieu P2 de sorte que la tension aux bornes du condensateur 16, et donc la tension $V_1$ aux bornes de l'éclateur à gaz 18, ne dépasse pas la tension d'amorçage de l'éclateur à gaz 30.

Suivant le même mode de fonctionnement décrite sur la figure 1, tant qu'une tension supérieure à la tension d'amorçage de l'éclateur à gaz 18 est appliquée en entrée, un clignotement de la diode optique, visible en sortie, se produit qui est fonction des cycles de charge et de décharge du condensateur 16.

Avantageusement, les valeurs de la résistance 26 et du condensateur 16 sont telles que l'énergie du condensateur 16 de l'étage principal 40 est suffisante pour que le clignotement de la diode soit visible par l'oeil humain.

Ainsi, suivant le mode de réalisation représenté sur la figure 2, le module de détection 10 a une plage de détection de tension très large. A titre d'exemple, en utilisant deux éclateurs à gaz 18, 30 avec une tension d'amorçage respective de 90V et de 3 kV, le module de détection 10 a une plage de détection de tension variant de 100V à 40kV.

Un autre mode de réalisation d'un module de détection 10 selon l'invention est illustré sur la figure 3. Il comporte une pluralité d'étages supplémentaires 28 disposées en parallèle entre la résistance 20 et le point milieu P1, chaque étage 28 étant propre à limiter la tension aux bornes de l'étage 28 aval avec lequel il est relié.

On appelle étage principale 40 la partie du circuit comprenant l'éclateur à gaz 18, la diode optique, la résistance 26 et le condensateur 16. Un premier étage 28 amont est relié à la résistance 20, un dernier étage 28 aval étant relié à l'étage principal 40. Chaque étage 28 amont comporte une tension seuil qui correspond à une tension de protection de l'étage 28 aval associé. La tension seuil d'un étage 28 amont donné est supérieure à la tension de l'étage aval 26, 40 en liaison direct afin de limiter la tension aux bornes de chaque étage aval 28, 40. La tension d'amorçage de l'éclateur à gaz 30 de chaque étage 28 amont correspond à la tension seuil choisie pour cet étage 28 et, par conséquent, cette valeur est supérieure à la tension d'amorçage et inférieur à la tension d'entretien de l'arc électrique de l'éclateur à gaz 30, respectivement 18, de l'étage 28, respectivement 40, aval en liaison direct.

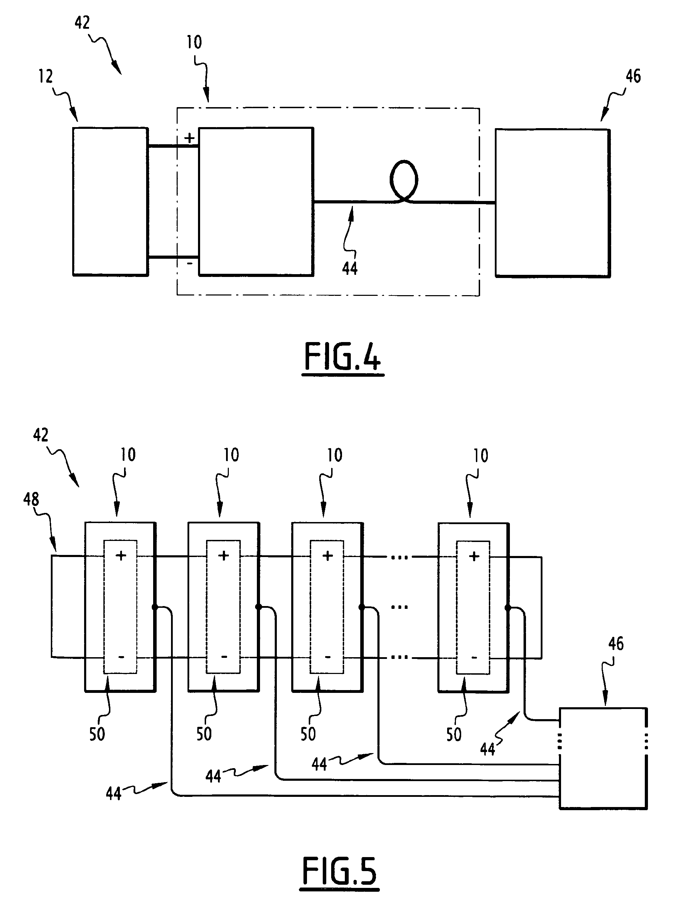

La figure 4 illustre un système de détection de tension 42 relié à une charge 12, par exemple un condensateur, comprenant un module de détection 10, tel que décrit ci-dessus, associé à une fibre optique 44, ainsi qu'un module 46 de détection optique et de traitement de l'information. Ce module 46 réalise la détection des impulsions lumineuses, leur traitement logique après conversion sous forme numérique et un affichage du résultat de la détection.

Le module de détection de tension 10 comprend une fibre optique 44, connectée en sortie de la diode optique. Avantageusement, la fibre optique 44 est une fibre optique en plastique. En variante, la fibre optique est une fibre optique en silice. L'autre extrémité de la fibre optique 44 est reliée au module 46 de détection optique et de traitement de l'information.

En cas de présence de tension, aux bornes de la charge 12, supérieure à la tension seuil, des impulsions lumineuses, générées par la diode optique, sont injectées dans la fibre optique 44 et transmises à distance. Ces impulsions lumineuses sont détectées, au niveau du module 46, par un photodétecteur associé à un amplificateur, destiné à amplifier le photocourant à un niveau suffisant. L'amplificateur est relié à un convertisseur analogique-numérique, permettant ainsi d'avoir les informations sous forme numérique. Ces informations sont envoyées à un calculateur propre à effectuer un traitement logique des données et sont mémorisées dans une mémoire interne. Un bouton est relié au calculateur afin d'effectuer une remise à zéro du système. Enfin, un afficheur, connecté au calculateur et comprenant au moins un voyant lumineux, permet de fournir une indication de la présence ou de l'absence de tension en entrée du système de détection de tension 42.

A titre d'exemple, l'afficheur comporte deux diodes optiques de couleur différentes. Une première diode, de couleur rouge par exemple, indique ainsi une présence de tension détectée à un moment donné depuis la dernière remise à zéro du système. Une seconde diode, de couleur verte par exemple, indique par contre une absence de tension détectée depuis la dernière remise à zéro du système.

Le traitement logique s'effectue par mémorisation successives d'une indication de présence de tension. Plus précisément, à chaque fois qu'une tension est détectée, sa présence est stockée dans un registre de la mémoire. Le calculateur envoie alors un signal de commande vers l'afficheur, afin d'allumer le voyant lumineux correspondant à une présence de tension. L'indication lumineuse correspondante reste présente jusqu'à ce qu'un utilisateur ne l'efface par une remise à zéro du système, si aucune tension résiduelle n'est détectée de nouveau. Dans le cas d'une absence de tension détectée, un autre indicateur s'allume alors.

En variante, le module 46 de détection optique et de traitement de l'information est propre à déterminer la fréquence des impulsions lumineuses reçues et à calculer la tension aux bornes de la charge 12.

Plus précisément, dans le cas où la tension VE en entrée est inférieure à la tension d'amorçage de l'éclateur à gaz 30, la fréquence de répétition des impulsions lumineuses suit la relation suivante :

$$F_{REP} = 1 / T_{REP} = 1 / (T_{CHARGE} + T_{DECHARGE})$$

Où $T_{REP}$ : Période de répétition des impulsions lumineuses,

$T_{CHARGE}$ : Temps de charge du condensateur 16 pour que la tension $V_{C1}$ aux bornes du condensateur 16 atteigne la tension d'amorçage de l'éclateur 16, et

$T_{DECHARGE}$ : Temps de décharge du condensateur 16 pour que la tension $V_{C1}$ aux bornes du condensateur 16 atteigne 0V.

Le temps de charge étant très supérieur au temps de décharge, la fréquence de répétition des impulsions lumineuses est donc égale à :

$$F_{REP} = 1 / T_{CHARGE}$$

La décharge du condensateur 16 suit l'égalité : $Q = C1 \times V_{C1} = Ic \times T_{CHARGE}$ avec

$$I_C = V_E / Z_C.$$

Où VC1 : Tension aux bornes du condensateur 16, VC1 correspondant à la tension d'amorçage VA1 de l'éclateur 16 après un temps de charge,
Ic : Courant de charge, généré par la charge 12,
VE : Tension en entrée, aux bornes de la charge 12, et
Zc : Impédance vue par la charge 12.

Ainsi, la fréquence des impulsions lumineuses est donc :

$$F_{REP} = V_E / (V_{A1} \times C_1 \times Z_C)$$

Par exemple, dans le cas de la figure 2, le calcul de l'impédance Zc permet d'obtenir la relation suivante :

$$Z_C = R_1 + (R_3 \times R_4 / R_3 + R_4) \text{ et avec } R_3 = R_4 = R_1 / 3, Z_C = R_1 + R_1/6$$

Ainsi, en choisissant Zc=R1 en première approximation, la fréquence des impulsions lumineuses est donc :

$$F_{REP} = V_E / (V_{A1} \times C_1 \times R_1)$$

Par exemple, si C1=100 nF, R1=90 MΩ, VA1= 90V :

$$F_{REP} = V_E / 810 \text{ soit } V_E = 810 \times F_{REP}$$

Par conséquent, la mesure de la fréquence des impulsions lumineuses permet une détermination de la tension VE en entrée, présente entre les bornes 22 et 24.

Pour des mesures de tension supérieures à la tension d'amorçage de l'éclateur à gaz 30, le système de détection de tension 42 comporte, en outre, une diode en série avec l'éclateur à gaz 30 de chaque étage supplémentaire 28 et des moyens de détection de la fréquence d'allumage de cette diode, laquelle correspond à la mise en court-circuit de l'éclateur à gaz 30 de l'étage supplémentaire 28 en fonctionnement. Les moyens de calcul de la tension sont propres, suivant le même principe que décrit précédemment, à établir la tension d'entrée VE en fonction de la tension d'amorçage VA2 de l'éclateur à gaz 30 de l'étage supplémentaire 28 en fonctionnement, des valeurs R1 de la résistance 20 et C2 du condensateur 34 et de la fréquence de répétition mesurée.

Ainsi, la tension VE en entrée est donc :

$$V_E = F_{REP} \times (V_{A2} \times C_2 \times R_1)$$

La figure 5 représente un système de détection de tension 42 associé à un banc d'énergie 48 comprenant N condensateurs haute tension 50. Ce système 42 est propre à détecter une présence de tension aux bornes de l'un quelconque des condensateurs 50. Un module de détection 10 est connecté aux bornes de chaque condensateur 48. Par conséquent, le système de détection de tension 42 comprend N modules de détection 10 dont chaque fibre optique 44 est connectée à une entrée du module de détection et de traitement de l'information 46. Le module de détection 46 comprend donc N entrées, toutes reliées une à une à des photorécepteurs munies d'amplificateurs en sortie. Ces amplificateurs sont connectées un à un à un convertisseur numérique-analogique. Suivant le même principe que pour la figure 4, le module de détection 46 comporte, en outre, un calculateur, une mémoire interne, un bouton et un afficheur.

En variante, l'afficheur comporte trois diodes optiques de couleur différentes. Les deux premières diodes, de couleur rouge et verte par exemple, fonctionnent sur un principe similaire à celui décrit précédemment. Ainsi, la diode rouge indique la présence de tension détectée aux bornes d'au moins un condensateur 50 alors que la diode verte indique une absence de tension détectée aux bornes de tous les condensateurs 50. La troisième diode, de couleur orange par exemple, indique quant à elle une présence de tension détectée sur tous les condensateurs 50. Toutes ces indications correspondent à une détection depuis la dernière remise à zéro du système.

Suivant le même mode de fonctionnement que pour le système 42 décrit sur la figure 4, à chaque fois qu'une tension est détectée sur l'un quelconque des condensateurs 50, la diode optique du module 10 correspondant génère des impulsions lumineuses qui sont transmises par la fibre optique 44 jusqu'à l'entrée correspondante du module 46. Les impulsions lumineuses sont reçues au niveau du photorécepteur, associé à l'entrée, qui convertit ces impulsions optiques en impulsions de courant analogique. Après amplification et conversion numérique, ces informations sont envoyées au calculateur et une indication de présence de tension est stockée dans un registre dédiée de la mémoire. Le calculateur génère un signal de commande vers l'afficheur, afin d'allumer le voyant lumineux correspondant. Ce voyant lumineux reste allumé jusqu'à ce qu'un utilisateur n'effectue un appui sur le bouton de remise à zéro du système. Cet appui provoque l'envoi d'une information au calculateur afin d'effacer tous les registres de la mémoire et un signal d'extinction est envoyé par le calculateur à l'afficheur dans le cas où aucune tension n'est détecté sur l'un des condensateurs, ce qui permet d'éteindre le voyant lumineux précédemment allumé. Dans le même temps, si aucune tension n'est détectée sur l'un quelconque des condensateurs 50, le calculateur envoie un signal à l'afficheur afin d'allumer un autre voyant lumineux, synonyme d'absence de tension, supérieure à la tension d'amorçage VA de l'étage 40 au niveau du système 42.

Par exemple, dans le cas de l'utilisation d'un module de détection 46, utilisant des diodes optiques comme voyants lumineux au niveau de l'afficheur, associé à un banc d'énergie comprenant 300 condensateurs 50 à tension de service de 24 kV, dès qu'une tension est détecté sur l'un au moins des condensateurs 50, la diode rouge s'allume, prévenant ainsi du danger les utilisateurs. Seule une remise à zéro du système, par un appui manuel de l'utilisateur, permet d'éteindre ce voyant, si aucune tension résiduelle n'est encore présente sur l'un condensateurs 50. De plus, si plus aucune tension n'est détecté sur l'un quelconque des condensateurs 50, le voyant vert s'allume, informant alors les utilisateurs d'une absence complète de danger.

Ainsi, le module de détection de tension 10, en tant que moyen de sécurité, présente l'avantage d'être autonome du fait de son absence de source d'alimentation. L'utilisation de fibres optiques permet également une très bonne isolation galvanique en rendant fiable et sûre l'information de sécurité en s'affranchissant de couplages électromagnétiques éventuels dans un environnement sévère haute tension. De plus, l'architecture du module 10 permet un fonctionnement sur une grande plage d'utilisation. Enfin, le système 42 permet une détection automatique de l'état des tensions en différents endroits, permettant une amélioration en termes de sécurité et en termes de facilités d'emploi. En effet, par rapport aux systèmes vérificateurs d'absence de tension actuels, le système 42 permet d'éviter de réaliser des vérifications unitaires manuelles de chaque charge.

## Revendications

1. Module de détection de tension (10) comprenant :

   - une première borne électrique (22),
   - une seconde borne de masse (24),
   - une résistance de charge (20), reliée à la première borne électrique (22),
   - un éclateur à gaz principal (18), disposée en série entre la résistance de charge (20) et la seconde borne (24), et
   - un condensateur principal (16), relié, d'une part, à un premier point milieu situé entre la résistance de charge (20) et l'éclateur à gaz principal (18) et, d'autre part, à la seconde borne (24),

   **caractérisé en ce qu'**il comporte, en outre, une source lumineuse (14) reliée en série entre l'éclateur à gaz principal (18) et la seconde borne (24), **en ce que** la source lumineuse (14) et l'éclateur à gaz principal (18) sont dissociés l'un de l'autre, et **en ce qu'**il comprend un étage supplémentaire (28) propre à limiter la tension appliquée aux bornes de l'éclateur à gaz principal (18) à une tension seuil choisie afin d'éviter que l'éclateur à gaz principal (18) ne soit toujours passant.

2. Module de détection de tension (10) selon la revendication 1, **caractérisé en ce qu'**il comprend, en outre, une résistance de limitation de courant (26), reliée en série d'une part à la source lumineuse (14) et d'autre part à la borne de masse (24).

3. Module de détection de tension (10) selon la revendication 2, **caractérisé en ce que** la source lumineuse (14) est une diode optique.

**4.** Module de détection de tension (10) selon selon l'une quelconque des revendications précédentes, **caractérisé en ce que** l'étage supplémentaire (28) comprend :

- une résistance d'étage (38) reliée d'une part au premier point milieu et d'autre part à un second point milieu, ce second point milieu étant relié à la résistance de charge (20),
- un éclateur à gaz secondaire (30) à tension d'amorçage spécifique, relié d'une part au second point milieu et d'autre part à un troisième point milieu, dont la tension d'amorçage correspond à la tension seuil choisie pour cet étage supplémentaire (28),
- un condensateur secondaire (34) à temps de charge et de décharge spécifique, disposé en parallèle de l'éclateur à gaz secondaire (30) et relié d'une part au second point milieu et d'autre part au troisième point milieu, et
- une résistance secondaire (32), reliée d'une part au troisième point milieu et d'autre part à la borne de masse (24).

**5.** Module de détection de tension (10) selon l'une quelconque des revendications précédentes, **caractérisé en ce que** l'étage supplémentaire (28) comprend, en outre, un condensateur antiparasite (36), disposé en parallèle de la résistance secondaire (32) et relié d'une part au troisième point milieu et d'autre part à la borne de masse (24).

**6.** Module de détection de tension (10) selon l'une quelconque des revendications 4 à 5, **caractérisé en ce que** les valeurs des résistances (20, 32, 38) et du condensateur principal (16) sont telles que le temps de charge du condensateur principal (16) est compris entre 50ms et 500ms.

**7.** Module de détection de tension (10) selon l'une quelconque des revendications 4 à 6, **caractérisé en ce qu'**il comprend une pluralité d'étages supplémentaires (28) disposés en parallèle entre la résistance de charge (20) et l'étage principal (40), un premier étage (28) amont étant relié à la résistance de charge (20), un dernier étage (28) aval étant relié à l'étage principal (40), chaque étage (28) amont ayant une tension seuil, correspondant à une tension de protection de l'étage (28, 40) aval associé, supérieure à l'étage (28, 40) aval relié directement, de façon à limiter la tension aux bornes de chaque étage (28, 40) aval.

**8.** Module de détection de tension (10) selon l'une quelconque des revendications précédentes, **caractérisé en ce qu'**il comprend, en outre, une fibre optique (44), connectée en sortie de la source lumineuse (14), propre à transmettre à distance une impulsion lumineuse produite par la source lumineuse (14).

**9.** Système de détection de tension (42) comprenant au moins un module de détection de tension (10) selon la revendication 8, **caractérisé en ce qu'**il comprend, en outre, un module de détection optique et de traitement de l'information (46), connecté à la fibre optique (44) de chaque module de détection de tension (10), propre à détecter l'impulsion lumineuse reçue en sortie de chaque fibre optique (44) et à déterminer la présence de tension aux bornes de chaque module de détection de tension (10).

**10.** Système de détection de tension (42) selon la revendication 9, **caractérisé en ce que** le module de détection optique et de traitement de l'information (46) est propre à déterminer la fréquence des impulsions lumineuses reçues et à calculer la tension présente entre les bornes (22), (24) en fonction de la fréquence des impulsions lumineuses.

**11.** Système de détection de tension (42) selon la revendication 10, **caractérisé en ce que** le module de détection de tension (10) comporte, en outre, une source lumineuse (14) en série avec l'éclateur à gaz secondaire (30) du ou de chaque étage supplémentaire (28) et **en ce que** le module de détection optique et de traitement de l'information (46) est propre à déterminer la fréquence des impulsions lumineuses reçues du ou de chaque source lumineuse du ou de chaque étage supplémentaire en fonctionnement et à calculer la tension présente entre les premières et secondes bornes (22, 24) en fonction des fréquences déterminées.

**Patentansprüche**

**1.** Spannungserfassungsmodul (10), umfassend:

- eine erste elektrische Klemmstelle (22),
- eine zweite Erdungsklemme (24),
- einen mit der ersten elektrischen Klemmstelle (22) verbundenen Lastwiderstand (20),

- einen zwischen dem Lastwiderstand (20) und der zweiten Klemme (24) reihengeschalteten Hauptgasabscheider (18) und
- einen mit einem zwischen dem Lastwiderstand (20) und dem Hauptgasabscheider (18) angeordneten ersten Sternpunkt einerseits und der zweiten Klemme (24) andererseits verbundenen Hauptkondensator (16),

**dadurch gekennzeichnet, dass** es ausserdem eine zwischen dem Hauptgasabscheider (18) und der zweiten Klemme (24) reihengeschaltete Lichtquelle (14) umfasst, dass die Lichtquelle (14) und dem Hauptgasabscheider (18) nicht miteinander verbunden sind, und dass es eine Zusatzebene (28) umfasst, die zur Einschränkung der auf die Klemmen des Hauptgasabscheiders (18) angewendeten Spannung auf eine Schwellenspannung geeignet ist, um zu vermeiden, dass sich der Hauptgasabscheider (18) dauernd in Betrieb befindet.

2. Spannungserfassungsmodul (10) nach Anspruch 1, **dadurch gekennzeichnet, dass** es ferner einen mit der Lichtquelle (14) einerseits und der Erdungsklemme (24) andererseits reihengeschalteten Strombegrenzungswiderstand (26) umfasst.

3. Spannungserfassungsmodul (10) nach Anspruch 2, **dadurch gekennzeichnet, dass** die Lichtquelle (14) eine optische Diode ist.

4. Spannungserfassungsmodul (10) nach einem der vorstehenden Ansprüche, **dadurch gekennzeichnet, dass** die Zusatzebene (28) umfasst:

- einen mit dem ersten Sternpunkt einerseits und einem zweiten Sternpunkt andererseits verbundenen Ebenenwiderstand (38), wobei der zweite Sternpunkt mit dem Lastwiderstand (20) verbunden ist,
- einen Nebengasabscheider (30) mit einer spezifischen Zündspannung, der mit dem zweiten Sternpunkt einerseits und einem dritten Sternpunkt andererseits verbunden ist, und dessen Zündspannung der für die Zusatzebene (28) gewählten Schwellenspannung entspricht,
- einen Nebenkondensator (34) mit einer spezifischen Ladungs- und Entladungszeit, der parallel zum Nebengasabschneider (30) angeordnet ist und mit dem zweiten Sternpunkt einerseits und dem dritten Sternpunkt andererseits verbunden ist, und
- einen mit dem dritten Sternpunkt einerseits und der Erdungsklemme (24) andererseits verbundenen Nebenwiderstand (32).

5. Spannungserfassungsmodul (10) nach einem der vorstehenden Ansprüche, **dadurch gekennzeichnet, dass** die Zusatzebene (28) ferner einen parallel zum Nebenwiderstand (32) angeordneten und mit dem dritten Sternpunkt einerseits und der Erdungsklemme (24) andererseits verbundenen Blockkondensator (36) umfasst.

6. Spannungserfassungsmodul (10) nach einem der Ansprüche 4 - 5, **dadurch gekennzeichnet, dass** die Werte der Widerstände (20, 32, 38) und des Hauptkondensators (16) derart sind, dass die Ladungszeit des Hauptkondensators (16) zwischen 50 und 500 ms liegt.

7. Spannungserfassungsmodul (10) nach einem der Ansprüche 4 - 6, **dadurch gekennzeichnet, dass** es eine Mehrzahl zwischen dem Lastwiderstand (20) und der Hauptebene (40) parallel angeordneter Zusatzebenen (28) umfasst, wobei eine erste vorgeschaltete Ebene (28) mit dem Lastwiderstand (20) verbunden ist, eine letzte nachgeschaltete Ebene (28) mit der Hauptebene (40) verbunden ist, und wobei alle vorgeschalteten Ebenen (28) eine einer Schutzspannung der damit verbundenen nachgeschalteten Ebene (28, 40) entsprechenden Schwellenspannung aufweisen, die höher ist als die nachgeschaltete Ebene (28, 40), so dass die auf die Klemmen jeder nachgeschalteten Ebene (28, 40) angewendete Spannung begrenzt wird.

8. Spannungserfassungsmodul (10) nach einem der vorstehenden Ansprüche, **dadurch gekennzeichnet, dass** es ferner einen mit dem Ausgang der Lichtquelle (14) verbundenen Lichtwellenleiter (44) umfasst, der geeignet ist, einen von der Lichtquelle (14) erzeugten Lichtimpuls über eine längere Strecke zu übertragen.

9. Spannungserfassungssystem (42), umfassend mindestens ein Spannungserfassungsmodul (10) nach Anspruch 8, **dadurch gekennzeichnet, dass** es ferner ein mit dem Lichtwellenleiter (44) jedes Spannungserfassungsmoduls (10) verbundenes optisches Erfassungs- und Datenverarbeitungsmodul (46) umfasst, das geeignet ist, den am Ausgang jedes Lichtwellenleiters (44) empfangenen Lichtimpuls zu erfassen und das Vorhandensein von Spannung an den Klemmen jedes Spannungserfassungsmoduls (10) zu erkennen.

**10.** Spannungserfassungssystem (42) nach Anspruch 9, **dadurch gekennzeichnet, dass** das optische Erfassungs- und Datenverarbeitungsmodul (46) geeignet ist, die Frequenz der empfangenen Lichtimpulse zu ermitteln und die zwischen den Klemmen (22, 24) vorhandene Spannung aufgrund der Frequenz der Lichtimpulse zu berechnen.

**11.** Spannungserfassungssystem (42) nach Anspruch 10, **dadurch gekennzeichnet, dass** das Spannungserfassungsmodul (10) ferner eine mit dem Nebengasabscheider (30) der bzw. jeder Zusatzebene (28) reihengeschaltete Lichtquelle (14) aufweist, und dass das optische Erfassungs- und Datenverarbeitungsmodul (46) geeignet ist, die Frequenz der von der bzw. jeder Lichtquelle der bzw. jeder sich im Betrieb befindenden Zusatzebene empfangenen zu ermitteln und die zwischen den ersten und zweiten Klemmen (22, 24) vorliegende Spannung aufgrund der ermittelten Frequenzen zu berechnen.

**Claims**

**1.** A voltage detection module (10) comprising:

- a first electric terminal (22),
- a second ground terminal (24),
- a load resistor (20), connected to the first electric terminal (22),
- a main gas-filled spark gap (18), arranged in series between the load resistor (20) and the second terminal (24), and
- a main capacitor (16), connected, on the one hand, to a first middle point situated between the load resistor (20) and the main gas-filled spark gap (18) and, on the other hand, to the second terminal (24),

**characterized in that** it also comprises a light source (14) connected in series between the main gas-filled spark gap (18) and the second terminal (24), **in that** the light source (14) and the main gas-filled spark gap (18) are separate from one another, and **in that** it comprises an additional stage (28) capable of limiting the voltage applied to the terminals of the gas-filled spark gap (18) to a threshold voltage chosen so as to prevent the gas-filled spark gap (18) from always being on.

**2.** A voltage detection module (10) according to claim 1, **characterized in that** it also comprises a current limiting resistor (26), connected in series on the one hand to the light source (14) and on the other hand to the ground terminal (24).

**3.** A voltage detection module (10) according to claim 2, **characterized in that** the light source (14) is an optical diode.

**4.** A voltage detection module (10) according to any one of the preceding claims, **characterized in that** the additional stage (28) comprises:

- a stage resistor (38) connected on the one hand to the first middle point and on the other hand to a second middle point, this second middle point being connected to the load resistor (20),
- a secondary gas-filled spark gap (30) with a specific starting voltage, connected on the one hand to the second middle point and on the other hand to a third middle point, the starting voltage of which corresponds to the threshold voltage chosen for that additional stage (28),
- a secondary capacitor (34) with a specific charge and depletion time, positioned in parallel with the secondary gas-filled spark gap (30) and connected on the one hand to the second middle point and on the other hand to the third middle point, and
- a secondary resistor (32), connected on the one hand to the third middle point and on the other hand to the ground terminal (24).

**5.** A voltage detection module (10) according to any one of the preceding claims, **characterized in that** the additional stage (28) also comprises an interference suppressor (36), positioned in parallel with the secondary resistor (32) and connected on the one hand to the third middle point and on the other hand to the ground terminal (24).

**6.** A voltage detection module (10) according to any one of claims 4 to 5, **characterized in that** the values of the resistors (20, 32, 38) and the main capacitor (16) are such that the charge time of the main capacitor (16) is between 50 ms and 500 ms.

**7.** A voltage detection module (10) according to any one of claims 4 to 6, **characterized in that** it comprises a plurality of additional stages (28) positioned in parallel between the load resistor (20) and the main stage (40), a first upstream stage (28) being connected to the load resistor (20), a last downstream stage (28) being connected to the main stage (40), each upstream stage (28) having a threshold voltage, corresponding to a protection voltage of the associated downstream stage (28, 40), higher than the directly-connected downstream stage (28, 40), so as to limit the voltage at the terminals of each downstream stage (28, 40).

**8.** A voltage detection module (10) according to any one of the preceding claims, **characterized in that** it also comprises an optical fiber (44), connected at the output of the light source (14), capable of remotely transmitting a light pulse produced by the light source (14).

**9.** A voltage detection system (42) comprising at least one voltage detection module (10) according to claim 8, **characterized in that** it also comprises an optical detection and information processing module (46), connected to the optical fiber (44) of each voltage detection module (10), capable of detecting the light pulse received in output from each optical fiber (44) and determining the presence of voltage at the terminals of each voltage detection module (10).

**10.** A voltage detection system (42) according to claim 9, **characterized in that** the optical detection and information processing module (46) is capable of determining the frequency of the received light pulses and calculating the voltage present between the terminals (22, 24) as a function of the frequency of the light pulses.

**11.** A voltage detection system (42) according to claim 10, **characterized in that** the voltage detection module (10) also comprises a light source (14) in series with the secondary gas-filled spark gap (30) of the or each additional stage (28) and **in that** the optical detection and information processing module (46) is capable of determining the frequency of the light pulses received from the or each light source of the or each additional stage during operation and calculating the voltage present between the first and second terminals (22, 24) as a function of the determined frequencies.

FIG.1

FIG.3

EP 2 463 669 B1

FIG.2

13

**FIG.4**

**FIG.5**

**RÉFÉRENCES CITÉES DANS LA DESCRIPTION**

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- US 4594546 A